Europäisches Patentamt

European Patent Office

Office européen des brevets

(19)

(11) EP 0 910 094 B1

(12) **FASCICULE DE BREVET EUROPEEN**

(45) Date de publication et mention
de la délivrance du brevet:
**31.03.2004 Bulletin 2004/14**

(51) Int Cl.⁷: **G11C 11/401**, G11C 11/403

(21) Numéro de dépôt: **98402478.6**

(22) Date de dépôt: **06.10.1998**

(54) **Dispositif de mémoire vive dynamique à durée de rafraîchissement réduite, et procédé correspondant de rafraîchissement**

Dynamische Speicheranordnung mit verkürzter Auffrischungszeit und entsprechende Auffrischungsverfahren

Dynamic RAM device with reduced refresh time, and corresponding refresh procedure

(84) Etats contractants désignés:
**DE FR GB IT**

(30) Priorité: **14.10.1997 FR 9712819**

(43) Date de publication de la demande:
**21.04.1999 Bulletin 1999/16**

(73) Titulaire: **STMicroelectronics S.A.**
**92120 Montrouge (FR)**

(72) Inventeur: **El Hajji, Noureddine**
**38100 Grenoble (FR)**

(74) Mandataire: **Casalonga, Axel**
**BUREAU D.A. CASALONGA - JOSSE**
**Paul-Heyse-Strasse 33**
**80336 München (DE)**

(56) Documents cités:
**EP-A- 0 681 331          US-A- 4 023 149**
**US-A- 5 020 028**

• **"NEW ARCHITECTURE OF TRANSPARENT REFRESH FOR RAM" IBM TECHNICAL DISCLOSURE BULLETIN, vol. 32, no. 12, 1 mai 1990, pages 271-273, XP000105357**

## Description

L'invention concerne les mémoires vives dynamiques (DRAM : "Dynamic Random Access Memory" en langue anglaise), et plus particulièrement leurs cycles de rafraîchissement.

Par opposition aux mémoires vives statiques (SRAM) dans lesquelles l'information mémorisée le reste indéfiniment du moins tant que ces mémoires restent alimentées, les mémoires dynamiques présentent la particularité de nécessiter un rafraîchissement périodique de l'information stockée en raison notamment des courants de fuites parasites qui déchargent la capacité de stockage de chaque cellule-mémoire (point-mémoire).

Ce rafraîchissement s'effectue classiquement au cours d'un cycle de lecture/ré-écriture nécessitant en conséquence une phase spécifique de ré-écriture de la donnée lue (car la lecture est destructive).

Parmi les cellules-mémoire connues de mémoire vive dynamique, on peut notamment citer celles comportant deux ou trois transistors et celles comportant un seul transistor dont la lecture de l'information détruit en outre cette dernière.

La durée totale de rafraîchissement d'une mémoire vive classique dont les cellules-mémoire sont organisées en lignes et en colonnes, dépend du nombre de lignes de la mémoire. En effet, l'homme du métier sait qu'on ne peut rafraîchir qu'une ligne à la fois en raison du caractère destructif de la lecture des informations mémorisées. Or il est particulièrement avantageux de pouvoir réduire la durée totale de rafraîchissement pour diminuer d'autant la période d'indisponibilité de la mémoire. Une solution connue consiste alors à subdiviser la mémoire en plusieurs blocs comportant chacun une matrice de cellules-mémoire. En sélectionnant alors simultanément une ligne dans chaque bloc, on diminue d'autant la durée de rafraîchissement. Cependant, dans chaque bloc, on ne peut sélectionner toujours qu'une seule ligne à la fois.

Un dispositif de mémoire vive dynamique selon le préambule de la revendication 1 est connu de US 5 020 028.

L'invention vise à proposer une structure radicalement différente de cellule-mémoire d'une mémoire vive dynamique, dont la lecture d'une donnée ne détruit pas cette dernière, permettant en outre, notamment, un rafraîchissement automatique très court de la donnée lue (ce rafraîchissement automatique ne nécessitant donc pas de phase spécifique de ré-écriture), et permettant par conséquent des cycles spécifiques de rafraîchissement au cours desquels plusieurs lignes de la matrice peuvent être sélectionnées de façon à rafraîchir simultanément plusieurs cellules.

L'invention a également pour but de proposer une structure de mémoire dont la surface occupée par les circuits nécessaires pour lire/écrire le plan mémoire ("overhead") est plus faible que celle des circuits correspondants associés aux mémoires vives dynamiques connues.

L'invention a également pour but de proposer une structure de mémoire utilisant un nombre moins important de niveaux de métallisation, ce qui diminue la probabilité de défaillance structurelle.

Telle que revendiquée, l'invention propose donc un dispositif de mémoire vive dynamique comportant au moins un bloc de cellules-mémoire organisées en lignes et en colonnes, ainsi que des moyens de sélection de ligne associés audit bloc et possédant un premier état (par exemple un état de lecture ou d'écriture) dans lequel ils sont aptes à sélectionner une seule ligne de cellules-mémoire dudit bloc. Selon une caractéristique générale de l'invention, toutes les cellules-mémoire d'une même colonne sont connectées par deux métallisations de colonne (une première métallisation de colonne ou "ligne de bits" et une métallisation de colonne de référence immédiatement adjacente), et comprennent chacune quatre transistors à effet de champ à grille isolée. Ces quatre transistors se répartissent en deux transistors de mémorisation et en deux transistors d'accès. Les deux transistors de mémorisation possèdent tous les deux un même quotient entre leur largeur de canal W1 et leur longueur de canal L1, tandis que les deux transistors d'accès possèdent tous les deux un même quotient entre leur largeur de canal W2 et leur longueur de canal L2. Le rapport entre le premier quotient W1/L1 et le deuxième quotient W2/L2 est choisi supérieur ou égal à 1 et, de préférence supérieur ou égal à 2.

Par ailleurs, le rapport entre la capacité d'une métallisation de colonne et la capacité grille/source de chaque transistor de mémorisation est au moins égale à 50, de préférence au moins égale à 100. En outre, les moyens de sélection de ligne possèdent un deuxième état (un état spécifique de rafraîchissement) dans lequel ils sont aptes à sélectionner simultanément plusieurs lignes de cellules-mémoire dudit bloc.

Comme on le verra plus en détail ci-après, la cellule-mémoire à quatre transistors selon l'invention peut être "rafraîchie", lue ou écrite. Mais en fait, lors d'un cycle de lecture, le rafraîchissement s'opère au début de ce cycle de lecture de telle sorte que la cellule-mémoire est automatiquement rafraîchie lorsqu'elle est lue. Or, au cours de cette opération, un pic de tension apparaît du côté du noeud qui avait été porté au potentiel nul lors de l'écriture. Et, si ce pic de tension est trop important, la cellule-mémoire peut perdre sa donnée, rafraîchir dans le mauvais sens et finalement fournir en lecture une donnée erronée.

Le choix du rapport entre les deux quotients W/L mentionné plus haut permet d'éviter un tel dysfonctionnement.

Par ailleurs, le fait que la capacité parasite de la métallisation de colonne soit très grande par rapport à la capacité de mémorisation grille/source permet d'obtenir une durée de rafraîchissement extrêmement courte, c'est-à-dire une durée extrêmement courte de transfert de charge de la capacité de métallisation de colonne vers la capacité grille/source d'un transistor de mémorisation. En conséquence, lorsqu'on rafraîchit un point mémoire, le niveau de précharge de la ligne de métallisation n'a quasiment pas évolué. Donc, même si l'on rafraîchit simultanément sur une même colonne, deux cellules-mémoire mémorisant respectivement un "1" logique et un "0" logique, l'opération de rafraîchissement ne créé pas une chute de tension suffisante sur la métallisation de colonne pour faire basculer les cellules-mémoire dans le mauvais sens et finalement rafraîchir des données ne correspondant pas aux données initialement mémorisées.

Bien entendu, plus le nombre de lignes sélectionnées est important, et plus, au sein d'une même colonne, le nombre de cellules-mémoire à rafraîchir et mémorisant un "0" est grand par rapport au nombre de cellules-mémoire à rafraîchir et mémorisant un "1", plus la chute de tension sur les métallisations de colonnes sera importante, et plus la qualité de l'information rafraîchie sera diminuée. En pratique, on sélectionnera typiquement huit lignes de cellules à la fois, c'est-à-dire que l'on choisira de rafraîchir au sein d'une même colonne huit cellules-mémoire à la fois.

Par ailleurs, lors d'un tel cycle spécifique de rafraîchissement, la durée de l'impulsion du signal transmis sur les lignes de mot ("word lines") sélectionnées doit être supérieure à la durée de transfert de charge de la capacité de métallisation de colonne vers la capacité grille/source d'un transistor de mémorisation. La durée de cette impulsion doit être également inférieure à la durée de décharge de la capacité de métallisation de colonne. En pratique, on choisira une durée d'impulsion voisine de la durée de transfert de charge de la capacité de métallisation de colonne vers la capacité grille/source d'un transistor de mémorisation.

Chaque cellule-mémoire comporte une première entrée et une deuxième entrée pour recevoir respectivement, lors des phases de lecture et d'écriture, deux tensions de commande (correspondant aux tensions appliquées sur les deux métallisations de colonne). Chaque cellule-mémoire comporte également une entrée de sélection pour recevoir une tension de sélection de ligne véhiculée par une métallisation spécifique de ligne ("ligne de mot" ou "wordline"). En outre, la source d'un premier transistor d'accès est reliée à la première entrée tandis que la source du deuxième transistor d'accès est reliée à la deuxième entrée. Le drain du premier transistor d'accès est relié au drain d'un premier transistor de mémorisation et à la grille du deuxième transistor de mémorisation, tandis que le drain du deuxième transistor d'accès est relié au drain du deuxième transistor de mémorisation et à la grille du premier transistor de mémorisation. Les sources des deux transistors de mémorisation sont reliées ensemble à une première tension de polarisation (par exemple la masse lorsqu'il s'agit de transistors NMOS ou bien la tension de niveau élevé VDD lorsqu'il s'agit de transistors PMOS). Enfin, les grilles des deux transistors d'accès sont reliées à l'entrée de sélection et par conséquent à la ligne de mot ("wordline").

Les quatre transistors peuvent être des transistors NMOS ou bien des transistors PMOS.

Pour diminuer les courants de fuite à travers notamment le chemin drain-source des transistors de mémorisation, et donc pour améliorer le temps de rétention de la donnée mémorisée, on peut polariser de façon appropriée le substrat de tous les transistors de façon à obtenir, en utilisant "l'effet substrat", une augmentation de la tension de seuil et par conséquent une augmentation de temps de rétention. Au sens de l'invention, le terme "substrat" ("bulk" en langue anglaise) désigne le substrat proprement dit lorsque le transistor n'est pas disposé dans un caisson, ou bien le caisson s'il en existe un.

Plus précisément, dans le cas de transistors NMOS, on polarisera avantageusement le caisson négativement tandis que dans le cas de transistors PMOS, on polarisera avantageusement le caisson à une tension supérieure à la tension VDD.

Plus généralement, on relie de préférence les substrats de tous les transistors à une deuxième tension de polarisation prédéterminée et l'on choisit les première et deuxième tensions de polarisation de telle sorte que la différence entre la deuxième tension de polarisation et la première tension de polarisation soit négative ou nulle dans le cas de transistors NMOS, tout en restant supérieure à l'opposé de la tension de seuil des transistors. Dans le cas des transistors PMOS, la différence entre la deuxième tension de polarisation et la première tension de polarisation est choisie positive ou nulle tout en restant inférieure à la somme de la première tension de polarisation et de la tension de seuil des transistors.

D'autres avantages et caractéristiques de l'invention apparaîtront à l'examen de la description détaillée d'un mode de réalisation, nullement limitatif et des dessins annexés sur lesquels :

- la figure 1 illustre schématiquement un plan mémoire d'une mémoire vive dynamique selon l'invention, et ses circuits associés,
- la figure 2 est une représentation schématique d'une cellule-mémoire selon l'invention réalisée à partir de transistors NMOS, et,
- les figures 3a-3c illustrent schématiquement un cycle de lecture de la cellule, comportant un rafraîchissement automatique de la donnée mémorisée, ainsi qu'un cycle spécifique de rafraîchissement ne comportant pas de lecture.

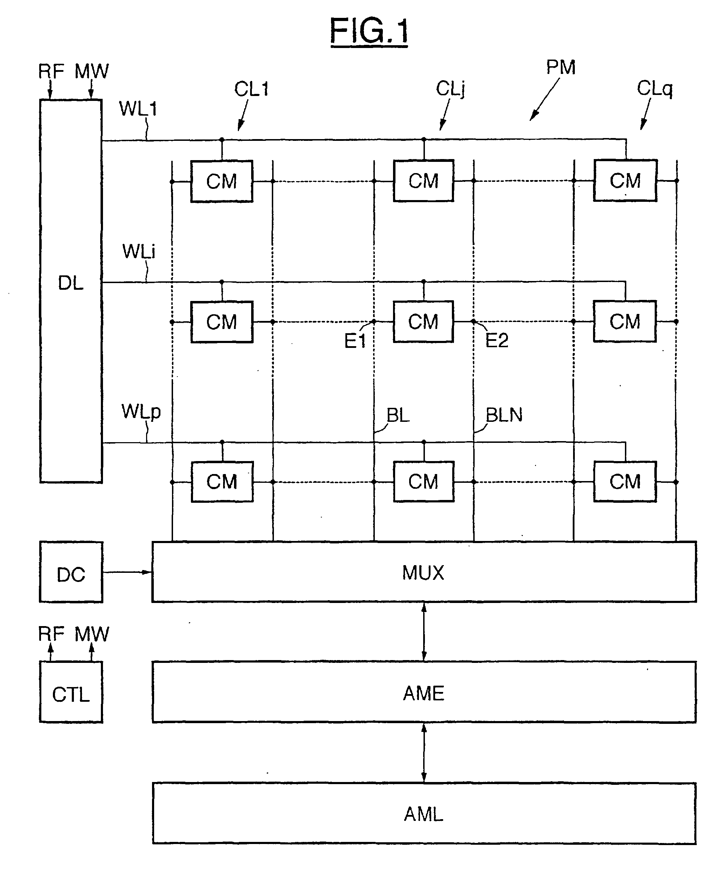

Sur la figure 1, on n'a représenté un dispositif de mémoire vive selon l'invention dont le plan mémoire PM comporte un seul bloc de cellules-mémoire CM organisées en lignes et en colonnes. Dans ; l'exemple décrit on suppose que le bloc mémoire comporte p lignes et q colonnes.

Chaque cellule-mémoire CM comporte deux entrées E1 et E2 respectivement connectées sur deux métallisations adjacentes de colonnes BL et BLN, pour recevoir des tensions de commande pour notamment la lecture et l'écriture de la donnée mémorisée dans la cellule-mémoire.

Par ailleurs, de façon classique, chaque cellule-mémoire est sélectionnée par un signal WL véhiculé par une métallisation de ligne WL ou "ligne de mot" ("wordline"). Le dispositif de mémoire comporte de façon classique, des circuits associés au plan mémoire PM et destinés à lire, écrire ou rafraîchir ce plan mémoire. Ces circuits comportent essentiellement un décodeur de ligne DL dont les sorties sont reliées aux différentes lignes de mots WLi pour délivrer les signaux de sélection WLi correspondants. Il est également prévu un décodeur de colonne DC associé à un multiplexeur MUX pour sélectionner une ou plusieurs colonnes CLj. Ainsi, en phase de lecture et d'écriture, la combinaison de la sélection d'une ligne de mot WLi et des colonnes CLj permet de sélectionner un mot mémoire du plan mémoire, contenu dans la même ligne de mots.

Le multiplexeur MUX est relié également de façon classique à un amplificateur d'écriture AME ainsi qu'à un amplificateur de lecture AML de réalisation connue en soi. Enfin, des moyens de contrôle CTL, de réalisation connue en soi, délivrent notamment des mots de commande MW au décodeur de ligne DL permettant de sélectionner en phase de lecture ou d'écriture une ligne de mot particulière WLi. En outre, selon l'invention, ces moyens de contrôle délivrent un signal de commande RF représentatif d'un rafraîchissement spécifique du plan mémoire et permettant, lorsque ce signal est activé, de sélectionner simultanément plusieurs lignes de mots du plan mémoire PM. On reviendra plus en détail sur ce point ci-après.

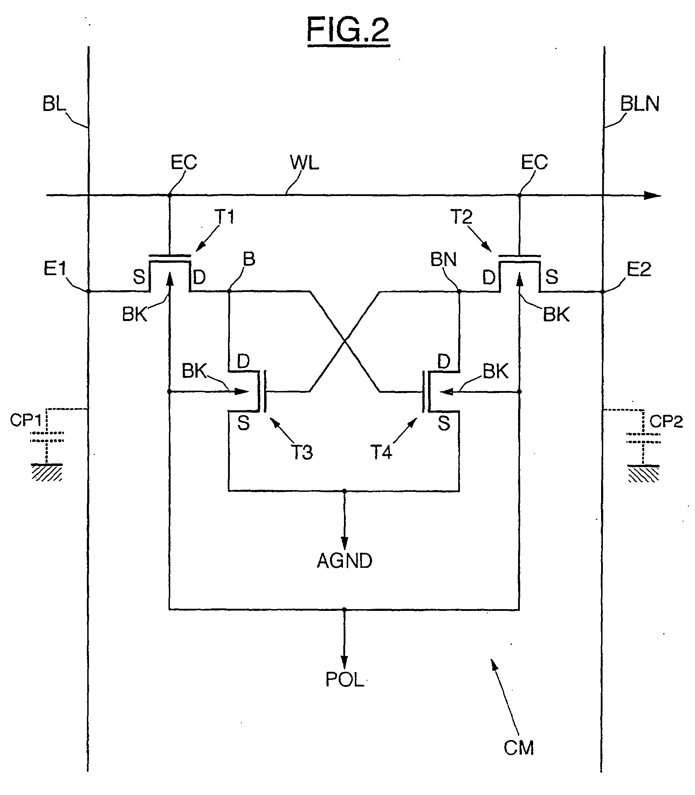

Chaque cellule-mémoire CM (figure 2) comporte deux transistors d'accès NMOS, respectivement référencés T1 et T2 dont les grilles respectives sont connectées sur la ligne de mot WL, les noeuds correspondants EC formant ainsi une entrée de sélection pour cette cellule-mémoire.

Outre les deux transistors d'accès T1 et T2, la cellule-mémoire CM comporte deux transistors NMOS de mémorisation T3 et T4. La capacité de stockage de la donnée mémorisée est formée par la capacité grille/source d'un transistor de mémorisation.

La grille du transistor T4 ainsi que le drain du transistor T3 sont reliés au drain du transistor d'accès T1, le noeud correspondant étant référencé B.

De même, la grille du transistor de mémorisation T3 ainsi que le drain du transistor de mémorisation T4 sont reliés au drain du transistor d'accès T2 le noeud correspondant étant référencé BN

Les sources respectives et transistors d'accès T1 et T2 sont respectivement reliés aux deux entrées de commande E1 et E2.

Enfin, les sources des deux transistors de mémorisation T3 et T4 sont reliées ensemble à une première tension de polarisation prédéterminée AGND.

Par ailleurs, le substrat BK de chaque transistor de la cellule-mémoire, ou bien le caisson BK de ce transistor si celui-ci est encaissonné, est avantageusement relié à une deuxième tension de polarisation POL.

Ceci étant, il est particulièrement avantageux que les transistors de la cellule-mémoire CM soient disposés dans un caisson (voire dans un double caisson) réalisé au sein d'un substrat semiconducteur. Ce mode de réalisation présente l'avantage d'offrir moins de fuites de courants, d'être moins sensible au "bruit" provenant du substrat, et d'être moins sensible aux particules alpha.

Afin de limiter les pertes de charge des capacités de stockage des transistors de mémorisation, et par conséquent pour augmenter le temps de rétention d'une donnée mémorisée, on choisit avantageusement les tensions POL et AGND de telle sorte que ces tensions vérifient la relation suivante :

$$- VT \leq POL - AGND \leq 0$$

dans laquelle VT désigne la tension de seuil des transistors.

En effet, une telle relation entre la tension POL et la tension AGND conduit à une différence de potentiel "source-substrat" positive ce qui, compte tenu de "l'effet substrat" bien connu de l'homme du métier, conduit à une augmentation de la tension de seuil et par conséquent à une augmentation du temps de rétention.

Dans l'exemple décrit ci-dessus, avec une technologie 0,35μ, et une tension AGND nulle, on choisira une tension POL sensiblement égale à -VDD/10 c'est à dire sensiblement égale à - 0,3 V.

Dans le cas où la cellule-mémoire est réalisée à partir de transistors PMOS, la tension de polarisation AGND est alors remplacée par la tension de polarisation AVDD, par exemple 3 V. Dans ce cas, toujours pour augmenter le temps de rétention de la donnée par utilisation de "l'effet substrat", on choisira les tensions AVDD et POL de façon à ce que :

$$VDD+VT \geq POL - AVDD \geq 0$$

Par ailleurs, la cellule-mémoire selon l'invention ne nécessite pas de procédé dédié de fabrication pour la réalisation de condensateurs de stockage, et ne nécessite que trois niveaux de métallisation pour sa réalisation en circuit intégré, alors qu'une cellule-mémoire à un transistor nécessite cinq niveaux de métallisation et cinq masques supplémentaires.

Pour illustrer le fonctionnement en écriture de la cellule-mémoire CM de la ligne de rang i et de la colonne de rang j, on suppose que l'on souhaite écrire un "1" logique.

On sélectionne la cellule CM d'une part en activant le signal logique WLi (WLi = 1) à partir d'un mot de commande spécifique MW et d'autre part en sélectionnant la colonne CLj. On applique alors sur les métallisations BL et BLN de la colonne CLj des tensions respectivement égales à VDD et 0.

Puisque les transistors d'accès T1 et T2 sont passants, la tension au noeud B est égale à VDD - VT tandis que la tension au noeud BN est nulle. Le transistor de mémorisation T3 est donc bloqué tandis que le transistor de mémorisation T4 est passant. La valeur "1" logique est par conséquent mémorisée dans la capacité grille-source du transistor T4. Il convient de noter ici que puisque le transistor T3 est bloqué, la tension au noeud B tend à garder sa valeur haute (si l'on fait abstraction bien sûr des fuites de courants parasites). De même, puisque le transistor T4 est passant, la tension au noeud BN tend à être maintenue à son niveau nul. En conséquence, l'homme du métier remarque ici le caractère de stabilité de la cellule-mémoire lors de la phase d'écriture. Ensuite, on désactive le signal WL, la donnée est alors considérée comme écrite.

Pour l'écriture d'un "0" logique, on applique une tension nulle sur la métallisation BL et une tension de niveau élevé (VDD) sur la métallisation BLN, C'est alors la capacité grille-source du transistor T3 qui stocke une charge résultant de l'application de la tension de niveau élevé au noeud BN.

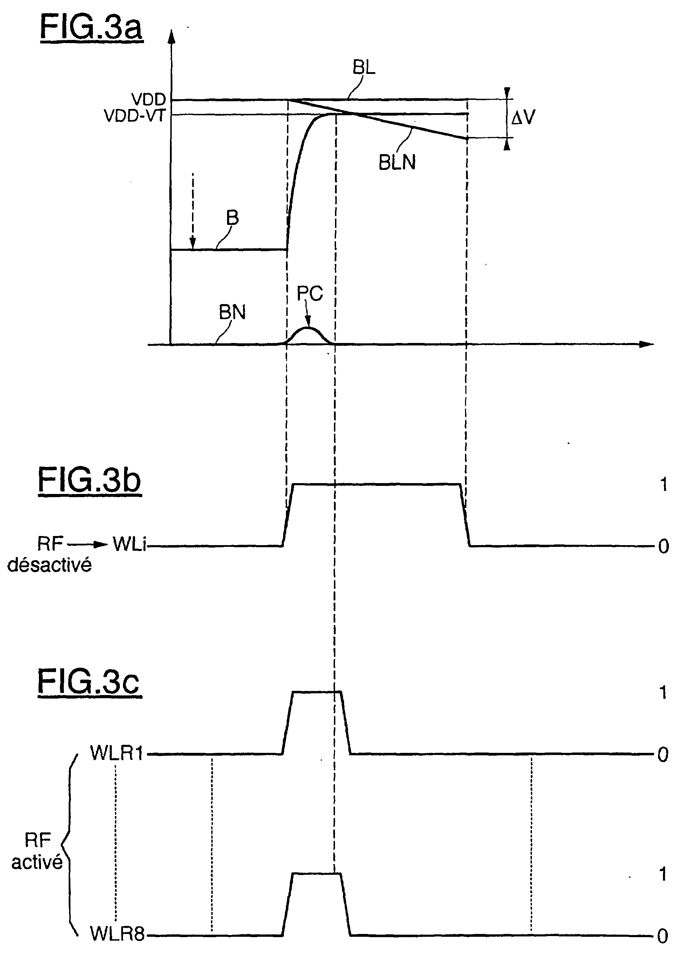

On se réfère maintenant plus particulièrement aux figures 3 a et 3b pour illustrer le fonctionnement de la cellule-mémoire en mode de lecture.

On suppose dans l'exemple qui va être décrit qu'un "1" logique a été préalablement mémorisé dans la cellule-mémoire.

D'une façon classique, la première étape consiste à précharger les métallisations BL et BLN de la colonne CLj à un niveau élevé de tension, en l'espèce VDD si le circuit de précharge comporte des transistors PMOS ou bien à VDD - VT si le circuit de précharge comporte des transistors NMOS.

On suppose également, qu'en raison des fuites dans le substrat, le potentiel au noeud B a subi une chute de tension par rapport au niveau initial VDD - VT qui lui a été appliqué lors de l'écriture de la donnée logique.

Après désactivation de la précharge, on active le signal WLi de sélection de ligne, ce qui a pour effet de rendre passants les deux transistors d'accès T1 et T2.

En conséquence, il se produit immédiatement un transfert de la charge de la capacité parasite CP1 de la métallisation BL vers le noeud B ce qui a pour effet de porter le potentiel de ce noeud B à sa valeur initiale VDD - VT. La durée de transfert est d'autant plus courte que le rapport entre la capacité de mémorisation grille/source et la capacité parasite CP1 (ou CP2) est faible, par exemple inférieur à 1/50. Ceci étant sur la figure 2, la durée de transfert de charge a été volontairement exagérée. L'homme du métier remarque donc que la cellule-mémoire selon l'invention présente la propriété remarquable de voir la donnée mémorisée automatiquement et quasi immédiatement rafraîchie au début d'un cycle de lecture. Il n'est donc pas nécessaire de prévoir un cycle spécifique de lecture ré-écriture pour rafraîchir la donnée mémorisée.

Par ailleurs, après activation du signal WLi, il se produit une décroissance du potentiel de la métallisation BLN par rapport au potentiel de la métallisation BL ce qui conduit à une différence de potentiel ΔV dont la lecture du signe permet de déterminer la valeur logique de la donnée mémorisée dans la cellule-mémoire.

Lors de l'activation du signal WLi, il se produit transitoirement un pic de tension PC au niveau du noeud BN. Il est indispensable ici d'éviter que ce pic de tension soit trop important et en particulier qu'il soit supérieur ou égal à la tension de seuil des transistors de mémorisation de façon à éviter que le transistor T3 ne devienne passant ce qui aurait pour effet alors de faire chuter la tension au noeud B et de bloquer le transistor T4 pour conduire finalement à une perte de l'information mémorisée, à un rafraîchissement de la donnée dans le "mauvais sens" et par conséquent à la lecture d'une donnée de valeur logique inverse de celle qui avait été préalablement écrite.

C'est pourquoi, il est nécessaire que le rapport

$$R = \frac{W1}{L1} \bigg/ \frac{W2}{L2} \,.$$

soit supérieur ou égal à 1 et de préférence supérieur ou égal à 2

(W1 et L1 désignant respectivement les largeur et longueur de canal des transistors de mémorisation tandis que W2 et L2 désignent les largeur et longueur de canal des transistors d'accès; la longueur correspond à la distance drain-source).

A titre indicatif pour une technologie CMOS 0,35μ, on choisira de préférence W1 = 1,4μ, L1 = 0,4μ, W2 = 0,8μ et L2 = 0,5μ ce qui conduit à un rapport R de l'ordre de 2,2.

La durée du cycle de lecture d'une telle cellule-mémoire est typiquement de l'ordre de 30ns tandis que la durée de rafraîchissement de l'information est beaucoup plus courte, typiquement de l'ordre de 5ns pour une capacité de mémorisation grille/source de l'ordre de quelques fentofarad et une capacité parasite de ligne de bit de l'ordre de quelques centaines de fentofarad.

D'une façon générale, lorsque le rapport entre la capacité parasite CP1 (ou CP2) d'une métallisation de colonne BL (ou BLN) et la capacité de mémorisation grille/source est suffisamment élevé, par exemple supérieur à 50, et mieux supérieur à 100, la cellule-mémoire selon l'invention présente la propriété remarquable de rafraîchir la donnée mémorisée dans cette cellule dans un temps extrêmement court. En effet, la durée de transfert de la charge vers la capacité de mémorisation est alors très faible par rapport à la durée de décharge de la capacité parasite de la métallisation de colonne.

Par ailleurs, lorsque l'on souhaite rafraîchir simultanément, sur une même colonne, deux cellules-mémoire dont l'une mémorise un "1" tandis que l'autre mémorise un "0", le potentiel de la métallisation de colonne a tendance à être tirée vers la valeur zéro lors du rafraîchissement du "0" logique ce qui est a priori contre-indiqué pour le rafraîchissement du "1" logique. Mais, puisque le rapport entre la capacité parasite de la métallisation de colonne et la capacité de mémorisation est très grand, et donc puisque le temps de rafraîchissement est très court, on observe que le niveau de tension sur la métallisation de colonne considérée ne varie pratiquement pas lors du rafraîchisssement. C'est la raison pour laquelle l'invention permet de sélectionner plusieurs lignes de mots simultanément, c'est-à-dire de rafraîchir simultanément plusieurs cellules-mémoire d'une même colonne.

Ceci étant, plus le nombre de cellules-mémoire sélectionnées dans une colonne et mémorisant un "0" logique est grand par rapport au nombre de cellules-mémoire sélectionnées dans cette même colonne mais mémorisant un "1" logique, plus le niveau de tension de métallisation de colonne va chuter et plus la qualité de l'information sera dégradée. En conséquence, l'homme du métier saura ajuster le nombre maximum de lignes pouvant être simultanément sélectionnées en fonction notamment de la technologie utilisée et des valeurs de capacité de parasite de métallisation. En pratique, on se limitera à la sélection simultanée de huit lignes de mots.

Pour effectuer de tels cycles spécifiques de rafraîchissement, c'est-à-dire des cycles spécifiques au cours desquels on ne procède pas à la lecture des données mémorisées, on délivre (par l'intermédaire des moyens DL et CTL), comme illustré plus particulièrement sur la figure 3c, sur chacune des lignes de mots sélectionnées, en espèce les lignes WL1-WL8, des impulsions spécifiques de rafraîchissement WLR1-WLR8 de durée très courte. En fait, la durée de ces impulsions doit être au moins égale à la durée de transfert de la charge dans la capacité de mémorisation d'une cellule-mémoire et inférieure à la durée de décharge de la capacité parasite de la métallisation de colonne. En pratique, on choisira des impulsions de durée légèrement supérieure à la durée de transfert de charge dans les capacités de mémorisation, c'est-à-dire, des impulsions dont la durée est légèrement supérieure à la durée de rafraîchissement des données mémorisées.

A cet égard, les moyens de contrôle délivrent au décodeur de lignes DL (figure 1) un signal spécifique de rafraîchissement RF ayant pour conséquence, lorsqu'il est activé, de sélectionner simultanément plusieurs lignes de mots. Bien entendu, lorsque ce signal RF n'est pas activé, le décodeur de ligne ne sélectionne qu'une seule ligne à la fois pour l'écriture ou la lecture de la mémoire. L'homme du métier saura aisément réaliser un tel décodeur de ligne à partir de portes logiques.

## Revendications

**1.** Dispositif de mémoire vive dynamique, comportant au moins un bloc de cellules-mémoire (CM) organisées en lignes et en colonnes ainsi que des moyens de sélection de ligne (DL) associés audit bloc et possédant un premier état dans lequel ils sont aptes à sélectionner une seule ligne de cellules-mémoire dudit bloc, toutes les cellules-mémoire (CM) d'une même colonne étant connectées entre deux métallisations de colonne (BL, BLN), et comprenant chacune quatre transistors à effet de champ à grilles isolées comprenant deux transistors de mémorisation (T3, T4) possédant tous les deux un même premier quotient entre leur largeur de canal (W1) et leur longueur de canal (L1), et deux transistors d'accès (T1, T2) possédant tous les deux un même deuxième quotient entre leur largeur de canal (W2) et leur longueur de canal (L2), le rapport (R) entre le premier quotient (W1/L1) et le deuxième quotient (W2/L2) étant supérieur ou égal à un, chaque cellule-mémoire (CM) comportant une première entrée (E1) et une deuxième entrée (E2) respectivement connectées sur les deux métallisations de colonne (BL, BLN), une entrée de sélection (EC) reliée aux moyens de sélection de ligne (DL), la source d'un premier transistor d'accès (T1) étant reliée à la première entrée (E1) tandis que la source du deuxième transistor d'accès (2) est reliée à la deuxième entrée (E2), le drain du premier transistor d'accès (T1) étant relié au drain d'un premier transistor de mémorisation (T3) et à la grille du deuxième transistor de mémorisation (T4), tandis que le drain du deuxième transistor d'accès (T2) est relié au drain du deuxième transistor de mémorisation (T4) et à la grille du premier transistor de mémorisation (T3), les sources des deux transistors de mémorisation étant reliés ensemble à une première tension de polarisation, les grilles des deux transistors d'accès étant reliées à l'entrée de sélection (EC), les moyens de sélection de ligne (DL) possédant un deuxième état dans lequel ils sont aptes à sélectionner simultanément plusieurs lignes de cellules-mémoire dudit bloc, **caractérisé par le fait que** le rapport entre la capacité d'une métallisation de colonne (CP1, CP2) et la capacité grille/source de chaque transistor de mémorisation (T3, T4) est au moins égal à 50, et **par le fait que** le dispositif comprend des moyens (CTL, DL) aptes à délivrer sur les lignes sélectionnées du bloc une impulsion (WLRi) dont la durée est supérieure à la durée de transfert de charge de la capacité de métallisation de colonne (CP1) vers la capacité grille/source d'un transistor de mémorisation, et inférieure à la durée de décharge de la capacité de métallisation de colonne.

**2.** Dispositif de mémoire, **caractérisé par le fait que** le rapport (R) des quotients est supérieur ou égal à deux.

**3.** Dispositif selon la revendication 1 ou 2, **caractérisé par le fait que** le rapport entre la capacité de métallisation de colonne (CP1, CP2) et ladite capacité grille/source est supérieur à 100.

**4.** Dispositif selon l'une des revendications précédentes, **caractérisé par le fait que** les quatre transistors (T1-T4) sont des transistors NMOS.

**5.** Dispositif selon la revendication 4, **caractérisé par le fait que** les substrats (BK) des transistors sont tous reliés à une deuxième tension de polarisation prédéterminée (POL), et **par le fait que** la différence entre la deuxième tension de polarisation et la première tension de polarisation est négative ou nulle et supérieure à l'opposé de la tension de seuil des transistors.

**6.** Dispositif selon l'une des revendications 1 à 3, **caractérisé par le fait que** les quatre transistors sont des transistors PMOS.

**7.** Dispositif selon la revendication 6, **caractérisé par le fait que** les substrats des transistors sont tous reliés à une deuxième tension de polarisation prédéterminée (POL), et **par le fait que** la différence entre la deuxième tension de polarisation et la première tension de polarisation est positive ou nulle et inférieure à la somme de première tension de polarisation et de la tension de seuil des transistors.

**8.** Procédé de rafraîchissement des données mémorisées dans un dispositif de mémoire vive dynamique tel que défini dans l'une des revendications 1 à 7, **caractérisé par le fait qu'**on met les moyens de sélection de ligne (DL) dans leur deuxième état, et **par le fait qu'**on transmet sur les lignes sélectionnées dudit bloc une impulsion (WLRi) dont la durée est supérieure à la durée de transfert de charge de la capacité de métallisation de colonne (CP1) vers la capacité grille/source d'un transistor de mémorisation, et inférieure à la durée de décharge de la capacité de métallisation de colonne.

**9.** Procédé selon la revendication 9, **caractérisé par le fait que** la durée de ladite impulsion est voisine de ladite durée de transfert de charge.

**Claims**

**1.** Dynamic random access memory device comprising at least one block of memory cells (CM) organized in rows and columns, as well as row selection means (DL) associated with the said block and possessing a first state in which they are able to select a single row of memory cells of the said block, all the memory cells (CM) of one and the same column being connected between two column metallizations (BL, BLN), and each comprising four insulated-gate field-effect transistors comprising two storage transistors (T3, T4) both possessing the same first quotient of their channel width (W1) to their channel length (L1), and two access transistors (T1, T2) both possessing the same second quotient of their channel width (W2) to their channel length (L2), the ratio (R) of the first quotient (W1/L1) to the second quotient (W2/L2) being greater than or equal to one, each memory cell (CM) comprising a first input (E1) and a second input (E2) respectively connected to the two column metallizations (BL, BLN), a selection input (EC) linked to the row selection means (DL), the source of a first access transistor (T1) being linked to the first input (E1) while the source of the second access transistor (2) is linked to the second input (E2), the drain of the first access transistor (T1) being linked to the drain of a first storage transistor (T3) and to the gate of the second storage transistor (T4), while the drain of the second access transistor (T2) is linked to the drain of the second storage transistor (T4) and to the gate of the first storage transistor (T3), the sources of the two storage transistors being together linked to a first bias voltage, the gates of the two access transistors being linked to the selection input (EC), the row selection means (DL) possessing a second state in which they are able to select several rows of memory cells of the said block simultaneously, **characterized in that** the ratio of the capacitance of a column metallization (CP1, CP2) to the gate/source capacitance of each storage transistor (T3, T4) is at least equal to 50, and **in that** the device comprises means (CTL, DL) which are able to deliver a pulse (WLRi) on the selected rows of the block, the duration of the pulse being greater than the duration of charge transfer from the column metallization capacitance (CP1) to the gate/source capacitance of a storage transistor, and less than the discharge duration of the column metallization capacitance.

**2.** Memory device, **characterized in that** the ratio (R) of the quotients is greater than or equal to two.

**3.** Device according to Claim 1 or 2, **characterized in that** the ratio of the column metallization capacitance (CP1, CP2) to the said gate/source capacitance is greater than 100.

4. Device according to one of the preceding claims, **characterized in that** the four transistors (T1-T4) are NMOS transistors.

5. Device according to Claim 4, **characterized in that** all the substrates (BK) of the transistors are linked to a second predetermined bias voltage (BIAS), and **in that** the difference between the second bias voltage and the first bias voltage is negative or zero and greater than the additive inverse of the threshold voltage of the transistors.

6. Device according to one of Claims 1 to 3, **characterized in that** the four transistors are PMOS transistors.

7. Device according to Claim 6, **characterized in that** all the substrates of the transistors are linked to a second predetermined bias voltage (BIAS), and **in that** the difference between the second bias voltage and the first bias voltage is positive or zero and less than the sum of the first bias voltage and the threshold voltage of the transistors.

8. Process for refreshing the data stored in a dynamic random access memory device such as defined in one of Claims 1 to 7, **characterized in that** the row selection means (DL) are placed in their second state, and **in that** a pulse (WLRi) is transmitted over the selected rows of the said block, the duration of the pulse being greater than the duration of charge transfer from the column metallization capacitance (CP1) to the gate/source capacitance of a storage transistor, and less than the discharge duration of the column metallization capacitance.

9. Process according to Claim 9 [sic], **characterized in that** the duration of the said pulse is approximately equal to the said duration of charge transfer.

**Patentansprüche**

1. Dynamische Lebendspeichervorrichtung, die mindestens einen Block Speicherzellen (CM) umfasst, die in Zeilen und Spalten organisiert sind, sowie Mittel zum Zeilenauswählen (DL), die mit dem Block verbunden sind und die einen ersten Zustand besitzen, in dem sie dazu geeignet sind, eine einzige Speicherzellenzeile des Blocks auszuwählen, wobei alle Speicherzellen (CM) einer gleichen Spalte zwischen zwei Spaltenmetallisierungen (BL, BLN) angeschlossen sind und jede vier Transistoren mit Feldeffekt mit isolierten Gittern umfassen, die zwei Speichertransistoren (T3, T4) umfassen, die beide einen gleichen ersten Quotienten zwischen ihrer Kanalbreite (W1) und ihrer Kanallänge (L1) haben, und zwei Zugangstransistoren (T1, T2), die beide einen gleichen zweiten Quotienten zwischen ihrer Kanalbreite (W2) und ihrer Kanallänge (L2) haben, wobei das Verhältnis (R) zwischen dem ersten Quotienten (W1/L1) und dem zweiten Quotienten (W2/L2) größer als oder gleich eins ist, wobei jede Speicherzelle (CM) einen ersten Eingang (E1) und einen zweiten Eingang (E2) umfasst, die jeweils an die zwei Spaltenmetallisierungen (BL, BLN) angeschlossen sind, einen Auswahleingang (EC), der an die Mittel zum Zeilenauswählen (DL) angeschlossen ist, wobei die Quelle eines ersten Zugangstransistors (T1) an den ersten Eingang (E1) angeschlossen ist, während die Quelle des zweiten Zugangstransistors (2) an den zweiten Eingang (E2) angeschlossen ist, wobei der Drain des ersten Zugangstransistors (T1) an den Drain eines ersten Speichertransistors (T3) angeschlossen ist und an das Gitter des zweiten Speichertransistors (T4), während der Drain des zweiten Zugangstransistors (T2) an den Drain des zweiten Speichertransistors (T4) angeschlossen ist und an das Gitter des ersten Speichertransistors (T3), wobei die Quellen der zwei Speichertransistoren gemeinsam an eine erste Polarisierungsspannung angeschlossen sind, wobei die Gitter der zwei Zugangstransistoren an den Auswahleingang (EC) angeschlossen sind, wobei die Mittel zur Zeilenauswahl (DL) einen zweiten Zustand besitzen, in dem sie dazu geeignet sind, gleichzeitig mehrere Speicherzellenzeilen des Blocks auszuwählen, **dadurch gekennzeichnet, dass** das Verhältnis zwischen der Kapazität einer Spaltenmetallisierung (CP1, CP2) und der Kapazität Gitter/Quelle jedes Speichertransistors (T3, T4) mindestens gleich 50 ist und dass die Vorrichtung Mittel (CTL, DL) umfasst, die auf die ausgewählten Zeilen des Blocks einen Impuls (WLRi) abgeben können, dessen Dauer größer ist als die Dauer des Ladungstransfers der Spaltenmetallisierungskapazität (CP1) zur Kapazität Gitter/Quelle eines Speichertransistors und kleiner als die Entladedauer der Spaltenmetallisierungskapazität.

2. Speichervorrichtung, **dadurch gekennzeichnet, dass** das Verhältnis (R) der Quotienten größer als oder gleich zwei ist.

3. Vorrichtung nach Anspruch 1 oder 2, **dadurch gekennzeichnet, dass** das Verhältnis zwischen der Spaltenmetallisierungskapazität (CP1, CP2) und der Kapazität Gitter/Quelle größer ist als 100.

4. Vorrichtung nach einem der vorhergehenden Ansprüche, **dadurch gekennzeichnet, dass** die vier Transistoren (T1-T4) NMOS-Transistoren sind.

5. Vorrichtung nach Anspruch 4, **dadurch gekenn-**

**zeichnet, dass** die Substrate (BK) der Transistoren alle an eine zweite vorbestimmte Polarisierungsspannung (POL) angeschlossen sind und dass der Unterschied zwischen der zweiten Polarisierungsspannung und der ersten Polarisierungsspannung negativ oder Null und größer als das Gegenteil der Schwellenspannung der Transistoren ist.

6. Vorrichtung nach einem der Ansprüche 1 bis 3, **dadurch gekennzeichnet, dass** die vier Transistoren PMOS-Transistoren sind.

7. Vorrichtung nach Anspruch 6, **dadurch gekennzeichnet, dass** die Substrate der Transistoren alle an eine zweite vorbestimmte Polarisierungsspannung (POL) angeschlossen sind und dass der Unterschied zwischen der zweiten Polarisierungsspannung und der ersten Polarisierungsspannung positiv oder Null und kleiner als die Summe der ersten Polarisierungsspannung und der Schwellenspannung der Transistoren ist.

8. Verfahren zum Auffrischen von Daten, die in einer dynamischen Lebendspeichervorrichtung wie in einem der Ansprüche 1 bis 7 definiert gespeichert sind, **dadurch gekennzeichnet, dass** man die Zeilenauswahlmittel (DL) in ihren zweiten Zustand versetzt und dass man auf den ausgewählten Zeilen des Blocks einen Impuls (WLRi) überträgt, dessen Dauer größer ist als die Dauer des Ladungstransfers von der Spaltenmetallisierungskapazität (CP1) zur Kapazität Gitter/Quelle eines Speichertransistors und kleiner als die Entladedauer der Spaltenmetallisierungskapazität.

9. Verfahren nach Anspruch 9, **dadurch gekennzeichnet, dass** die Dauer des Impulses in der Nähe der Ladungstransferdauer liegt.

# FIG.1

# FIG.2

## FIG.3a

VDD
VDD-VT

BL

ΔV

BLN

B

PC

BN

## FIG.3b

RF ⟶ WLi
désactivé

1

0

## FIG.3c

WLR1

1

0

RF
activé

WLR8

1

0